# FASCICULE DE BREVET EUROPEEN

(11) **EP 3 459 907 B1**
(45) Date de publication et mention de la délivrance du brevet: **12.08.2020**
(21) Numéro de dépôt: 18196058.4
(22) Date de dépôt: 21.09.2018
(51) Int. Cl.: B81C 1/00

(54) **MICRO-DISPOSITIF COMPORTANT UN ELEMENT PROTEGE CONTRE UNE GRAVURE HF ET FORME D'UN MATERIAU COMPRENANT UN SEMI-CONDUCTEUR ET UN METAL**
MIKRO-VORRICHTUNG, DIE EIN ELEMENT UMFASST, DAS GEGEN EINE HF-ÄTZUNG GESCHÜTZT IST, UND FORM EINES MATERIALS, DIE EINEN HALBLEITER UND EIN METALL UMFASST
MICRODEVICE COMPRISING AN ELEMENT PROTECTED AGAINST HF ETCHING AND FORMED FROM A MATERIAL COMPRISING A SEMICONDUCTOR AND A METAL

(30) Priorité: 25.09.2017 FR 1758848
(43) Date de publication de la demande: 27.03.2019
(73) Titulaire: Commissariat à l'énergie atomique et aux énergies alternatives, 75015 Paris (FR)
(72) Inventeur: LOUWERS, Stephanus, 38500 La Buisse (FR)
(74) Mandataire: Brevalex

(56) Documents cités:
- US-A1- 2010 065 934

## Description

### DOMAINE TECHNIQUE ET ART ANTÉRIEUR

L'invention concerne le domaine des micro-dispositifs, c'est-à-dire des micro-systèmes électromécaniques (MEMS) et/ou des nano-systèmes électromécaniques (NEMS) et/ou des micro-systèmes opto-électromécaniques (MOEMS) et/ou nano-systèmes opto-électromécaniques (NOEMS), comportant par exemple des éléments mobiles. Par la suite, le terme « micro-dispositif » est utilisé pour désigner en particulier un dispositif de type MEMS et/ou NEMS et/ou MOEMS et/ou NOEMS. L'invention concerne par exemple un micro-dispositif de type capteur et/ou actionneur.

Au cours de la réalisation d'un micro-dispositif, il arrive souvent qu'une ou plusieurs étapes de libération d'éléments du micro-dispositif (par exemple des doigts interdigités ou d'autres types d'éléments mobiles ou statiques) soient mises en œuvre par gravure HF (acide fluorhydrique) vapeur et/ou liquide, afin de graver des matériaux tels que du SiO₂ présents au-dessus et/ou en dessous des couches de semi-conducteur et/ou des couches métalliques de ces éléments. Or, une telle gravure est problématique lorsqu'un siliciure, par exemple du WSi₂, se retrouve au contact du HF en raison de la dégradation engendrée par le HF sur le siliciure. Par exemple, si une couche de WSi₂ d'épaisseur égale à environ 100 nm formée sur une couche de SiO₂ elle-même disposée sur un substrat de silicium est en contact avec du HF sous forme vapeur, une délamination du WSi₂ se produit alors en raison de l'attaque des joints de grain par le HF.

Le siliciure peut être volontairement utilisé dans le micro-dispositif, par exemple pourformer un ou plusieurs éléments de ce micro-dispositif, en raison de sa faible résistance électrique de contact, de sa capacité à relier du semi-conducteur de type N avec du semi-conducteur de type P sans formation de diode, de sa compatibilité avec des procédés auto-alignés ou bien encore de sa résistance aux hautes températures. Le siliciure peut également être présent involontairement dans le micro-dispositif, par exemple en raison d'une réaction d'un élément métallique sur lequel se trouve du silicium qui est déposé à haute température, ce qui engendre la formation de siliciure à l'interface entre le métal et le silicium.

Ce problème de dégradation au contact du HF se retrouve également lorsque le siliciure est composé d'un métal autre que du tungstène, par exemple du titane, mais également pour d'autres matériaux correspondant à des composés d'au moins un semi-conducteur et d'au moins un métal, et qui ne sont pas compatibles avec le HF, c'est-à-dire qui se dégrade en présence de HF. Un exemple d'un tel dispositif est présenté dans le brevet US2010/065934. Le dispositif et le procédé présentés dans ce document comportent une portion de matériau correspondant à un composé d'au moins un semi-conducteur et d'au moins un métal, ainsi que de couches de protection faites de tantale.

### EXPOSÉ DE L'INVENTION

Un but de la présente invention est de proposer un micro-dispositif comprenant un élément formé d'un matériau correspondant à un composé de semi-conducteur et de métal et qui n'est pas compatible avec le HF, et qui soit protégé vis-à-vis d'une gravure HF.

Pour cela, la présente invention propose un micro-dispositif comportant au moins un premier élément comprenant au moins :
- une portion de matériau correspondant à un composé d'au moins un semi-conducteur et d'au moins un métal,
- des première et deuxième couches de protection recouvrant chacune une de deux faces opposées de ladite portion de matériau, telles que la première couche de protection comprenne au moins un premier matériau apte à résister à une gravure HF, que la deuxième couche de protection comprenne au moins un deuxième matériau apte à résister à la gravure HF, et qu'au moins l'un des premier et deuxième matériaux aptes à résister à la gravure HF comporte le semi-conducteur.

De plus, les première et deuxième couches de protection sont en contact direct avec la portion de matériau à protéger.

Ainsi, l'invention propose de réaliser un ou plusieurs éléments du micro-dispositif sous la forme d'un empilement comprenant une portion de matériau correspondant à un composé d'au moins un semi-conducteur et d'au moins un métal, par exemple un siliciure, interposée entre des couches de protection formées de matériaux résistants à une gravure HF et protégeant ainsi la portion de matériau lors d'une gravure HF. La portion de matériau peut ainsi conférer à ce ou ces éléments la ou les propriétés souhaitées, par exemple la résistance électrique souhaitée, et les couches de protection rendent la présence de ce ou ces éléments compatible avec la mise en œuvre d'une gravure HF.

En outre, l'un des premier et deuxième matériaux aptes à résister à la gravure HF comporte le semi-conducteur du composé formant la portion de matériau à protéger, ce qui signifie que le composé peut être réalisé par réaction d'au moins un métal et de ce matériau semi-conducteur d'au moins l'une des première et deuxième couches de protection.

L'invention s'applique pour n'importe quel type de micro-dispositif comportant un tel matériau correspondant à un composé de semi-conducteur et de métal, par exemple un siliciure, et devant subir des étapes de gravure HF. L'invention peut ainsi éviter une délamination ou une gravure (ou attaque) de ce composé semi-conducteur - métal.

Un composé d'au moins un semi-conducteur et d'au moins un métal correspond à un matériau dont la composition atomique comporte un ou plusieurs atomes du semi-conducteur et un ou plusieurs atomes de ce métal.

Un matériau apte à résister à une gravure HF peut correspondre à un matériau qui n'est pas dégradé lorsque celui-ci est en contact avec le HF, ou plus généralement un matériau sur lequel une attaque HF n'aura pas d'impact sur le fonctionnement du micro-dispositif.

De préférence, les matériaux aptes à résister à une gravure HF peuvent présenter une vitesse de gravure, vis-à-vis du HF, inférieure ou égale à environ 1 nm/min.

Les deux faces opposées de la portion de matériau qui sont recouvertes des première et deuxième couches de protection peuvent correspondre aux deux faces principales de la portion de matériau. L'expression « faces principales » de la portion de matériau désigne les faces ayant les surfaces les plus importantes de la portion de matériau. Les deux faces opposées de la portion de matériau qui sont recouvertes des première et deuxième couches de protection peuvent correspondre aux faces supérieure et inférieure de la portion de matériau. Ces deux faces opposées de la portion de matériau peuvent être sensiblement parallèles à un substrat sur lequel le micro-dispositif est réalisé.

Il est également décrit une structure destinée à former un micro-dispositif, comportant au moins un premier élément comprenant au moins :
- une portion de matériau correspondant à un composé d'au moins un semi-conducteur et d'au moins un métal,
- des première et deuxième couches de protection recouvrant chacune une de deux faces opposées de ladite portion de matériau, telles que la première couche de protection comprenne au moins un premier matériau apte à résister à une gravure HF, que la deuxième couche de protection comprenne au moins un deuxième matériau apte à résister à la gravure HF, et qu'au moins l'un des premier et deuxième matériaux aptes à résister à la gravure HF comporte le semi-conducteur.

Cette structure peut comporter au moins un matériau apte à être gravé par une gravure HF, disposé autour d'au moins une partie du premier élément, et/ou du côté de la première couche de protection et/ou de la deuxième couche de protection. Plus généralement, ce matériau apte à être gravé par une gravure HF peut être disposé au voisinage ou à proximité du premier élément tel que lors de sa gravure par du HF, la première couche de protection et/ou la deuxième couche de protection protègent la portion de matériau du premier élément vis-à-vis du HF.

Le semi-conducteur peut comporter du Si et/ou le métal peut comporter par exemple au moins l'un des éléments chimiques suivants : W, Ti, Co, Ru, Ta, Pt, Ni, et/ou les premier et deuxième matériaux aptes à résister à la gravure HF peuvent comporter par exemple au moins l'un des composés chimiques suivants : Si, SiN, AIN, Al₂O₃, HfO₂. De manière avantageuse, la portion de matériau peut comporter du WSi₂ et les première et deuxième couches de protection peuvent comporter du silicium.

Le premier élément peut faire partie d'un élément fixe du micro-dispositif. Le premier élément peut correspondre par exemple à un élément d'interconnexion de doigts d'un peigne fixe, ou statique, destiné à être interdigité avec un autre peigne du micro-dispositif dont les doigts sont mobiles.

Le micro-dispositif peut comporter en outre un substrat auquel le premier élément peut être relié par au moins une portion diélectrique. Cette portion diélectrique peut former au moins un élément de liaison fixe du premier élément au substrat.

Le micro-dispositif peut comporter en outre un ou plusieurs composants microélectroniques réalisés sur le substrat. Le micro-dispositif peut par exemple être co-intégré sur le substrat avec un circuit électronique par exemple de type CMOS.

Le micro-dispositif peut comporter en outre au moins un deuxième élément relié au premier élément par au moins une portion semi-conductrice disposée entre le deuxième élément et l'une des première et deuxième couches de protection. Un tel deuxième élément peut correspondre par exemple à un ou plusieurs doigts d'un peigne statique, c'est-à-dire non mobile, destiné à être interdigité avec un peigne mobile du micro-dispositif. Les doigts du peigne statique peuvent être interconnectés électriquement par l'intermédiaire de la portion de matériau du premier élément.

Le premier élément peut comporter en outre au moins un espaceur recouvrant au moins une partie des faces latérales, sensiblement perpendiculaires aux deux faces principales ou opposées, de la portion de matériau du premier élément et comprenant au moins un troisième matériau apte à résister à la gravure HF.

L'autre des premier et deuxième matériaux aptes à résister à la gravure HF peut comporter le semi-conducteur ou un matériau diélectrique.

L'invention concerne également un procédé de réalisation d'un micro-dispositif, au cours duquel au moins un premier élément du micro-dispositif est réalisé en mettant en œuvre au moins les étapes de :
- réalisation d'un empilement d'une première couche et de deux deuxièmes couches telles que la première couche soit disposée entre les deux deuxièmes couches, que la première couche comporte au moins un métal, que l'une des deux deuxièmes couches comprenne au moins un premier matériau apte à résisterà une gravure HF, que l'autre des deux deuxièmes couches comprenne au moins un deuxième matériau apte à résister à la gravure HF, et qu'au moins l'un des premier et deuxième matériaux aptes à résister à la gravure HF comporte un semi-conducteur ;
- traitement thermique faisant réagir une partie du semi-conducteur avec le métal, formant une portion de matériau correspondant à un composé du semi-conducteur et du métal, et tel qu'au moins une partie restante de chacune des deux deuxièmes couches forment des première et deuxième couches de protection recouvrant chacune une de deux faces opposées de ladite portion de matériau ;
et comprenant en outre la mise en œuvre d'une étape de gravure HF au cours de laquelle ladite portion de matériau est protégée du HF par les première et deuxième couches de protection.

Le procédé peut comporter en outre, après l'étape de réalisation de l'empilement, une étape de gravure de l'empilement des première et deuxièmes couches selon un motif définissant géométriquement au moins le premier élément.

Dans ce cas, le procédé peut comporter en outre, après l'étape de réalisation de l'empilement, les étapes de :
- dépôt d'une couche diélectrique recouvrant au moins des portions restantes de l'empilement (pouvant correspondre aux parties de l'empilement qui sont conservées après la gravure de l'empilement, ou bien correspondre à la portion de matériau et aux première et deuxième couches de protection si le traitement thermique est mis en œuvre avant ce dépôt) ;
- gravure d'une partie de la couche diélectrique, formant au moins un accès au premier élément ;
- dépôt d'un matériau semi-conducteur dans l'accès formé à travers la couche diélectrique et sur la couche diélectrique, formant un deuxième élément relié au premier élément par au moins une portion de semi-conducteur disposée entre le deuxième élément et le premier élément ;
et l'étape de gravure HF peut être mise en œuvre telle qu'elle supprime la couche diélectrique.

Le procédé peut comporter en outre, avant la mise en œuvre de la gravure HF, une étape de réalisation d'au moins un espaceur recouvrant au moins une partie des faces latérales, sensiblement perpendiculaires aux deux faces opposées, de la portion de matériau du premier élément et comprenant au moins un troisième matériau apte à résister à la gravure HF.

L'empilement peut être réalisé sur une autre couche diélectrique disposée sur un substrat.

Dans ce cas, l'étape de gravure HF peut graver également ladite autre couche diélectrique telle qu'au moins une portion restante de ladite autre couche diélectrique relie le premier élément au substrat.

Le procédé peut comporter en outre la réalisation d'un ou plusieurs composants microélectroniques sur le substrat.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1, 13 et 14 représentent un micro-dispositif comportant au moins un élément formé d'un composé d'au moins un semi-conducteur et d'au moins un métal et protégé vis-à-vis d'une gravure HF, objet de la présente invention, selon un premier mode de réalisation,
- les figures 2 à 8 représentent les étapes d'un procédé de réalisation du micro-dispositif selon le premier mode de réalisation,
- la figure 9 représente un micro-dispositif comportant au moins un élément formé d'un composé d'au moins un semi-conducteur et d'au moins un métal et protégé vis-à-vis d'une gravure HF, objet de la présente invention, selon un deuxième mode de réalisation,
- la figure 10 représente un micro-dispositif comportant au moins un élément formé d'un composé d'au moins un semi-conducteur et d'au moins un métal et protégé vis-à-vis d'une gravure HF, objet de la présente invention, selon un troisième mode de réalisation,
- les figures 11 et 12 représentent une partie des étapes d'un procédé de réalisation du micro-dispositif selon le troisième mode de réalisation ;
- les figures 15 et 16 représentent un micro-dispositif intégré avec un circuit CMOS.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

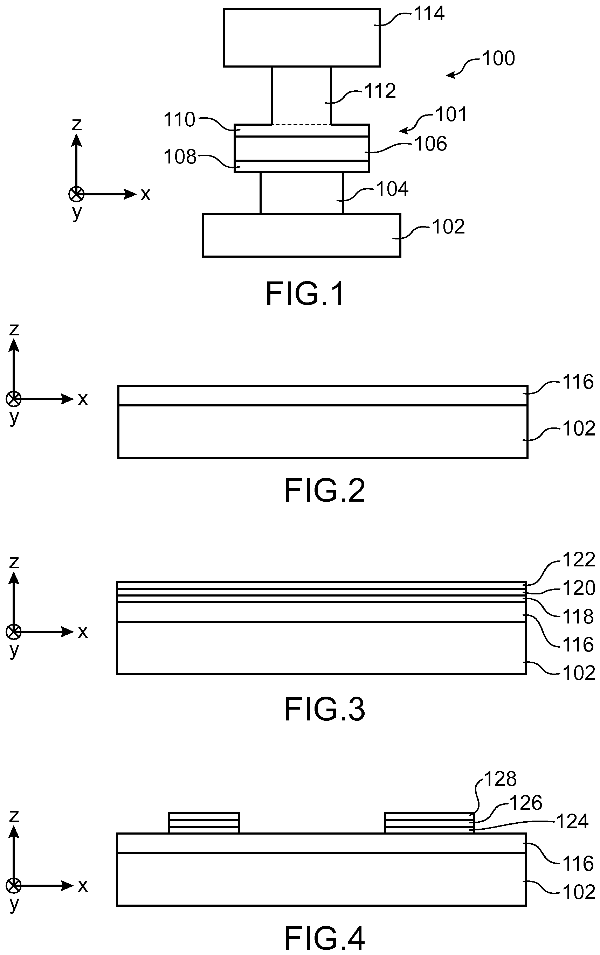

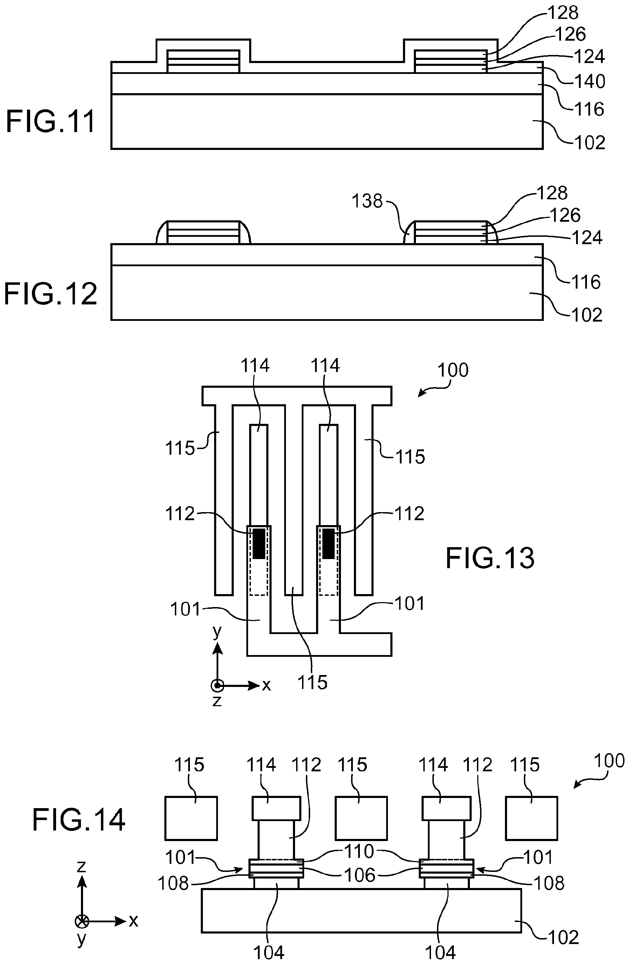

On se réfère tout d'abord à la figure 1 qui représente une partie d'un micro-dispositif 100 selon un premier mode de réalisation. Les figures 13 et 14 représentent une vue plus globale du micro-dispositif 100.

Ce micro-dispositif 100 est par exemple un capteur et/ou un actionneur, et comporte un ou plusieurs éléments 101 réalisés à partir d'un matériau correspondant à un composé d'au moins un semi-conducteur et d'au moins un métal, avantageusement un siliciure (c'est-à-dire un matériau comprenant du silicium et au moins un métal) et par exemple du WSi₂. Le ou les éléments 101 du micro-dispositif 100 comprenant ce matériau peuvent correspondre à un ou plusieurs éléments fixes du micro-dispositif 100, par exemple un élément d'interconnexion de doigts d'un peigne fixe du micro-dispositif 100. La figure 1 représente une vue en coupe d'une partie du micro-dispositif 100 sur laquelle l'un de ces éléments 101 est visible.

Le micro-dispositif 100 est réalisé sur un substrat 102 formant un support du micro-dispositif 100. Ce substrat 102 comporte ici un semi-conducteur, par exemple du silicium et/ou du germanium. Son épaisseur (dimension selon l'axe Z représenté sur la figure 1) est par exemple égale à plusieurs centaines de microns, et est par exemple comprise entre environ 400 µm et 750 µm.

Une ou plusieurs portions diélectriques 104 (une seule visible sur la figure 1) sont présentes sur le substrat 102, formant une ou plusieurs portions de maintien du ou des éléments 101 du micro-dispositif 100 sur le substrat 102. La portion diélectrique 104 comporte par exemple un oxyde de semi-conducteur, avantageusement du SiO₂. L'épaisseur de la portion diélectrique 104 (dimension selon l'axe Z représenté sur la figure 1) est par exemple comprise entre environ 100 nm et 3 µm.

L'élément 101 visible sur la figure 1 comporte une portion 106 du matériau comprenant au moins un semi-conducteur et au moins un métal (par exemple du WSi₂), disposée entre deux couches de protection 108, 110. Les couches de protection 108, 110 comportent chacune un matériau apte à résister à une gravure HF, par exemple au moins un semi-conducteur tel que du silicium. La couche de protection inférieure 108 est disposée entre les portions 104 et 106, et la couche de protection supérieure 110 est disposée entre la portion 106 et une autre portion 112 reliant l'élément 101 à un autre élément 114 de micro-dispositif 100. La portion 112 et l'élément 114 comportent par exemple un semi-conducteur tel que du silicium. La portion 106 est en contact direct avec les couches de protection 108, 110.

Les couches de protection 108, 110 ont pour rôle de protéger la portion 106 vis-à-vis d'une attaque HF au cours de la réalisation du micro-dispositif 100. La couche de protection inférieure 108 recouvre l'ensemble de la face arrière de la portion 106 (celle se trouvant du côté de la portion 104 et du substrat 102) et est en contact avec la portion 104, et la couche de protection supérieure 110 recouvre l'ensemble de la face supérieure de la portion 106 (celle se trouvant du côté de la portion 112 et de l'élément 114) et est en contact avec la portion 112. Les faces supérieure et inférieure de la portion 106 forment les faces principales de la portion 106. Chacune des couches de protection a une épaisseur (dimension selon l'axe Z visible sur la figure 1) par exemple comprise entre environ 10 nm et 300 nm.

L'épaisseur de la portion 106 (dimension selon l'axe Z visible sur la figure 1) est par exemple comprise entre environ 150 nm et 600 nm.

Sur les figures 13 et 14, outre les éléments 101 et 114, des éléments mobiles 115 du peigne qui est interdigité avec celui comprenant les éléments 114 sont représentés.

En variante de ce premier mode de réalisation, il est possible que l'une des couches de protection 108, 110 comporte non pas un semi-conducteur mais au moins un matériau diélectrique résistant à une gravure HF. Un tel matériau diélectrique correspond par exemple à du SiN, du HfO₂, de l'Al₂O₃ ou encore de l'AlN.

Selon une autre variante, il est possible que les couches de protection 108, 110 comportent chacune un matériau semi-conducteur différent de l'autre. Dans ce cas, le composé formant la portion 106 peut incorporer des éléments chimiques, ou atomes, de l'un ou de chacun de ces deux semi-conducteurs.

Un exemple de procédé de réalisation du micro-dispositif 100 selon le premier mode de réalisation est décrit ci-dessous en lien avec les figures 2 à 8.

Le micro-dispositif 100 est réalisé à partir du substrat 102 sur lequel est formée une couche diélectrique 116 à partir de laquelle les portions 104 sont destinées à être réalisées (figure 2). Lorsque la couche diélectrique 116 comporte un oxyde de semi-conducteur, elle peut être réalisée par oxydation du semi-conducteur du substrat 102. L'épaisseur de la couche diélectrique 116 (dimension selon l'axe Z visible sur la figure 2) correspond à celle des portions 104 destinées à être réalisées, et est par exemple comprise entre environ 100 nm et 3 µm.

Sur la figure 3, une couche 118 du matériau destiné à former la couche de protection inférieure 108, ici du silicium, est déposée sur la couche diélectrique 116. La couche 118 peut être déposée par PVD (dépôt physique en phase vapeur). L'épaisseur de la couche 118 (dimension selon l'axe Z visible sur la figure 3) est par exemple comprise entre environ 75 nm et 550 nm.

En variante, la couche diélectrique 116 et au moins une partie de la couche 118 peuvent être présentes initialement sur le substrat 102, par exemple en utilisant un substrat SOI.

Une couche métallique 120, à partir de laquelle les portions 106 sont destinées à être réalisées, est ensuite déposée sur la couche 118. Dans l'exemple de réalisation décrit ici, le matériau de la couche métallique 120 correspond à du tungstène. L'épaisseur de la couche métallique 120 (dimension selon l'axe Z visible sur la figure 3) est par exemple comprise entre environ 50 nm et 200 nm. La couche métallique 120 peut être réalisée en mettant en œuvre un dépôt PVD.

Enfin, une autre couche 122 du matériau destiné à former la couche de protection supérieure 110, ici du silicium, est déposée sur la couche métallique 120. La couche 122 peut être déposée par PVD (dépôt physique en phase vapeur). L'épaisseur de la couche 122 (dimension selon l'axe Z visible sur la figure 3) est par exemple comprise entre environ 75 nm et 550 nm.

De manière avantageuse, les couches 118 et 122 peuvent comporter par exemple du silicium amorphe déposé par PVD.

Lorsque les couches 118, 120, 122 sont toutes déposées par PVD, ces trois étapes de dépôt peuvent être mises en œuvre au cours d'un seul passage du substrat 102 et de la couche diélectrique 116 dans un équipement de dépôt PVD, sans remise à l'air de l'ensemble entre ces étapes de dépôt.

Un masque, dont le motif correspond à celui des portions 106 et des couches de protection 108, 110, est ensuite formé sur la couche 122. Une photolithographie et une gravure, par exemple par plasma, des couches 118, 120, 122 sont ensuite mises en œuvre afin de former des portions 124, 126, 128 respectivement des couches 118, 120, 122 à partir desquelles les portions 106 et les couches de protection 108, 110 vont être réalisées (figure 4). Le motif, dans le plan principal du substrat 102 (plan (X,Y) sur la figure 4), des empilements formés par les portions 124, 126, 128 correspond à celui des empilements 106, 108, 110 destinés à être réalisés. Le masque est ensuite supprimé, par exemple par vois plasma puis par voie chimique.

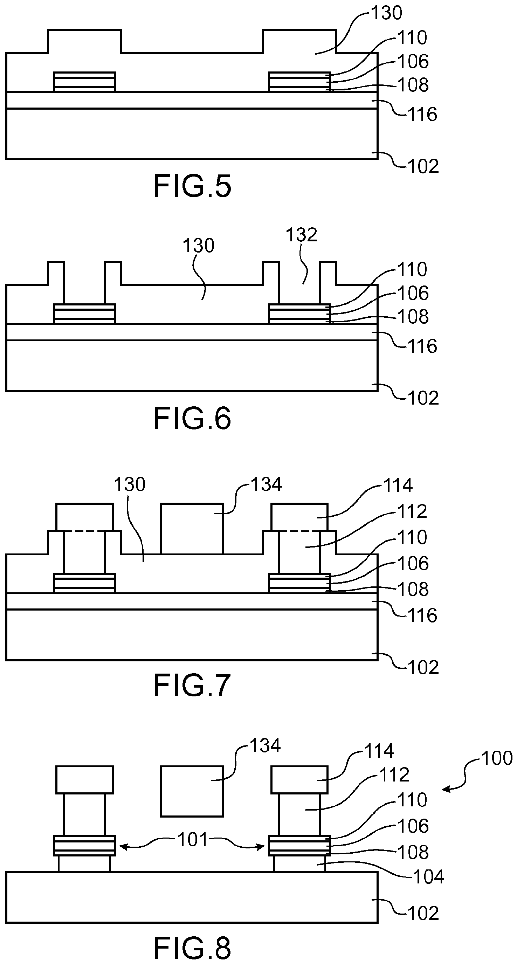

Comme représenté sur la figure 5, une couche diélectrique 130, comprenant par exemple du SiO₂, est déposée en recouvrant la couche diélectrique 116 ainsi que les portions 128. Cette couche diélectrique 130 correspond à celle destinée à être gravée par HF ultérieurement

Un recuit est ensuite mis en œuvre afin que le matériau des portions 126 et celui des portions 124, 128 (ou d'une seule des portions 124, 128 lorsque l'autre de ces deux portions comporte non pas un semi-conducteur mais un matériau diélectrique), qui sont en contact les uns avec les autres, réagissent et forment le matériau définitif des portions 106 correspondant à un composé du métal de la couche 120 et du ou des matériaux semi-conducteurs d'une ou des couches 118, 122. Ce recuit est par exemple mis en œuvre à une température comprise entre environ 500°C et 1000°C. Lorsque ce recuit est destiné à former des portions 106 de WSi₂ à partir de portions de tungstène disposées entre des portions de silicium, ce recuit est par exemple mis en œuvre à une température égale à environ 900°C.

Dans l'exemple de réalisation décrit ici, le métal (tungstène) des portions métalliques 126 réagit avec le semi-conducteur (silicium) des portions 124, 128 pour former le composé (WSi₂) des portions 106. De manière avantageuse, le matériau d'au moins l'une des portions 124, 128, et qui correspond au matériau d'au moins l'une des couches de protection 108, 110, correspond à du silicium afin que le matériau des portions 106 obtenu à la fin du recuit corresponde à un siliciure. Lorsque l'une des deux couches de protection 108, 110 comporte un matériau diélectrique, ce matériau diélectrique ne réagit pas avec le métal des portions métalliques 126 pour former le matériau définitif des portions 106.

Au cours de ce recuit, le ou les matériaux semi-conducteur d'une ou des portions 124, 128 réagissent avec le métal des portions métalliques 126. Ainsi, l'épaisseur des couches de protection 108, 110 obtenues après la mise en œuvre de ce recuit est inférieure à celle des portions 124, 128 avant le recuit, et l'épaisseur des portions 106 obtenues après ce recuit est supérieure à celle des portions métalliques 126 avant le recuit. Ainsi, il convient de choisir judicieusement les épaisseurs initiales des couches 118, 120, 122 afin qu'à la fin du recuit, une partie des portions 124, 128 soit toujours présente contre les faces principales des portions 106 afin de protéger ces portions depuis ces faces. Dans l'exemple décrit ici où les portions 124, 128 comportent du silicium et le métal des portions 126 est du tungstène, l'épaisseur initiale de chacune des couches 118, 120 peut être comprise entre environ 75 nm et 550 nm afin qu'à l'issue du recuit, l'épaisseur finale de chacune des couches de protection 108, 110 soit comprise entre environ 10 nm et 300 nm.

Selon une variante, il est possible que le recuit soit mis en œuvre avant le dépôt de la couche diélectrique 130, voire même avant l'étape de gravure des couches 118, 120, 122.

Dans ce cas, ou lorsque ce recuit et la réaction correspondante entre les matériaux des portions 126 d'un côté, et des portions 124 et/ou 128 d'un autre côté, provoquent une rugosité trop importante, une étape de planarisation (par exemple par CMP, ou polissage mécano-chimique) peut être mise en œuvre afin de réduire cette rugosité, et faciliter ainsi la mise en œuvre des opérations suivantes.

Après ce recuit, et éventuellement après l'étape de planarisation, une lithographie et une gravure sont mises en œuvre à travers la couche diélectrique 130 afin de former des accès 132 aux empilements des portions 106 et des couches de protection 108, 110, avec arrêt sur le matériau des couches de protection 110 (figure 6).

Comme représenté sur la figure 7, un nettoyage est ensuite mis en œuvre, puis un dépôt, par exemple par épitaxie, est réalisé afin d'obtenir une couche de matériau destinée à former notamment les portions 112 et 114. Une planarisation mécanochimique puis une lithographie et une gravure achèvent la formation des portions 112, 114 en contact avec les empilements des portions 106 et des couches de protection 108, 110. D'autres parties 134 du matériau déposé servent à former d'autres éléments du micro-dispositif 100.

Le procédé est achevé en réalisant une gravure HF de la couche diélectrique 130 (figure 8). Lors de cette gravure, les couches de protection 108 et 110 protègent les portions 106 du côté de leurs faces avant et arrière. Cette gravure forme également les portions 104 à partir de la couche diélectrique 116.

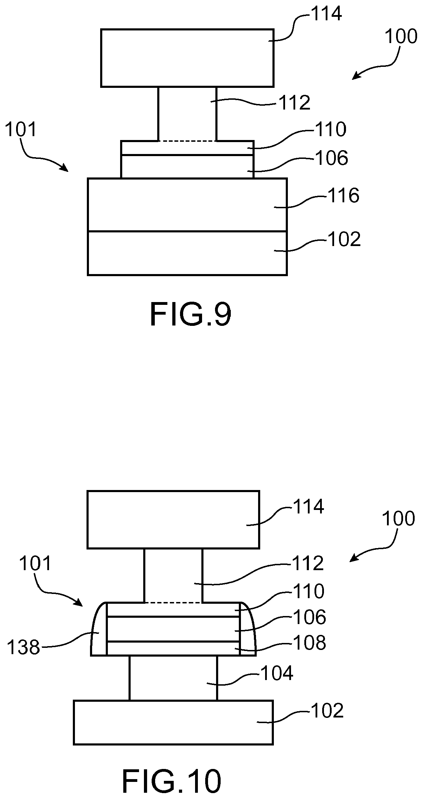

La figure 9 représente le micro-dispositif 100 selon un deuxième mode de réalisation.

Par rapport au premier mode de réalisation décrit précédemment, la couche de protection inférieure 108 et la portion diélectrique 104 correspondent à un seul élément diélectrique formé par la couche diélectrique 116. Cet élément diélectrique recouvre l'ensemble de la face arrière de la portion 106 et le matériau diélectrique de cet élément correspond à un matériau résistant à une gravure HF, comme par exemple du SiN, du HfO₂, de l'Al₂O₃ ou encore de l'AlN. La portion 106 est en contact direct avec la couche de protection 110 et la couche diélectrique 116.

Pour réaliser un tel micro-dispositif 100, la couche 116 est réalisée avec un matériau et une épaisseur adaptée pour former cet élément diélectrique. Les dépôts des couches 120 et 122 précédemment décrits en lien avec la figure 3 sont ensuite mis en œuvre, la couche 120 étant formée directement sur la couche diélectrique 116. Les étapes précédemment décrites en lien avec les figures 4 à 8 sont ensuite mises en œuvre comme dans le premier mode de réalisation.

Dans les modes de réalisation décrits précédemment, les faces latérales des portions 106 ne sont pas protégées lors de la gravure HF. Toutefois, les éléments 101 ont généralement des dimensions latérales importantes, par exemple de plusieurs microns voire plusieurs dizaines de microns, ce qui limite l'impact de la gravure HF au niveau des faces latérales des portions 106.

Il est toutefois possible de protéger les faces latérales des portions 106. La figure 10 représente le micro-dispositif 100 selon un troisième mode de réalisation dans lequel ces faces latérales sont protégées lors de la gravure HF.

Le micro-dispositif 100 selon ce troisième mode de réalisation comporte tous les élément du micro-dispositif 100 selon le premier mode de réalisation, et notamment les portions 106 disposées entre les couches de protection 108, 110 et en contact direct avec ces couches de protection 108, 110. Toutefois, le micro-dispositif 100 selon ce troisième mode de réalisation comporte en outre, contre les faces latérales des portions 106, des espaceurs 138 protégeant ces faces latérales contre la gravure HF mise en œuvre au cours du procédé. Ces espaceurs 138 ont par exemple une largeur de l'ordre de 100 nm. Les espaceurs 138 comportent un matériau résistant à une gravure HF, et par exemple un ou plusieurs des matériaux suivants : Si, AlN, Al₂O₃, HfO₂, SiN. De plus, sur l'exemple représenté sur la figure 10, ces espaceurs 138 recouvrent également les faces latérales des couches de protection 108, 110. Ces espaceurs 138 sont ici également en contact direct avec les portions 106.

A titre d'exemple, lorsque le matériau des portions 106 correspond à du TiSi₂ ou du CoSi₂, le micro-dispositif 100 est de préférence réalisé tel que les faces latérales des portions 106 soient protégées par les espaceurs 138. Lorsque le matériau des portions 106 correspond par exemple à du Ru₂Si₃, du TaSi₂, du PtSi ou encore du NiSi₂, le micro-dispositif 100 peut être réalisé avec ou sans les espaceurs 138. Le choix de la présence ou non des espaceurs 138 peut être fait en fonction de la sensibilité du matériau des portions 106 vis-à-vis du HF.

Un procédé de réalisation du micro-dispositif 100 selon le troisième mode de réalisation est décrit ci-dessous en lien avec les figures 11 et 12.

Les étapes précédemment décrites en lien avec les figures 2 à 4 sont tout d'abord mises en œuvre. Ensuite, préalablement au dépôt de la couche diélectrique 130, une couche 140 destinée à former les espaceurs 138 est déposée en recouvrant la couche diélectrique 116 ainsi que les portions 128 (figure 11). Cette couche 140 correspond soit à une unique couche d'un seul matériau, soit à un empilement de plusieurs matériaux.

La couche 140 est ensuite gravée afin que des portions restantes de cette couche 140 correspondent aux espaceurs 138 (figure 12).

La réalisation du micro-dispositif 100 est achevée en mettant en œuvre les étapes précédemment décrites en lien avec les figures 5 à 8.

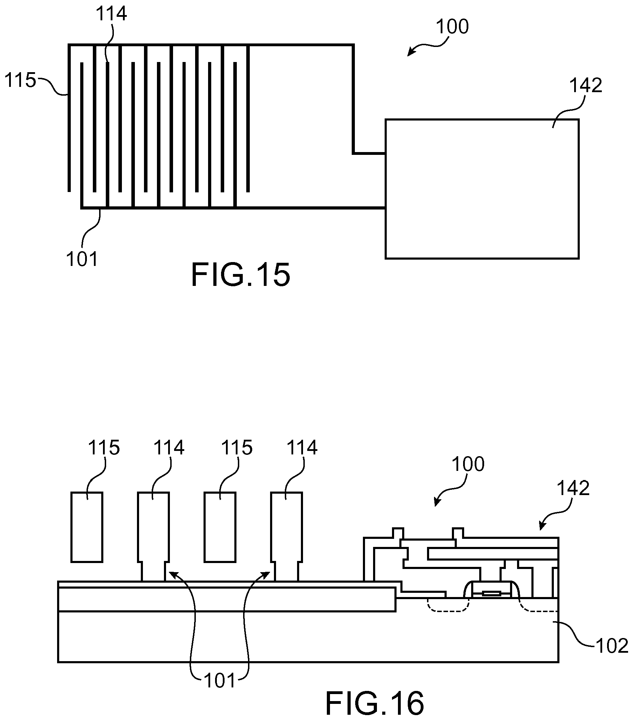

Quel que soit le mode de réalisation du micro-dispositif 100, ce micro-dispositif 100 peut comporter ou être intégré avec un ou plusieurs dispositifs microélectroniques, comme par exemple des composants de type MOS. Les figures 15 et 16 représentent le micro-dispositif 100 lorsqu'il est intégré sur le substrat 102 avec un circuit CMOS 142 couplé aux peignes interdigités formés par les doigts 114, 115.

## Revendications

1. Micro-dispositif (100) comportant au moins un premier élément (101) comprenant au moins :
- une portion de matériau (106) correspondant à un composé d'au moins un semi-conducteur et d'au moins un métal,
- des première et deuxième couches de protection (108, 110) recouvrant chacune une de deux faces opposées de ladite portion de matériau (106), telles que les première et deuxième couches de protection (108, 110) soient en contact direct avec ladite portion de matériau (106), que la première couche de protection (108) comprenne au moins un premier matériau apte à résister à une gravure HF, que la deuxième couche de protection (110) comprenne au moins un deuxième matériau apte à résister à la gravure HF, et qu'au moins l'un des premier et deuxième matériaux aptes à résister à la gravure HF comporte le semi-conducteur.

2. Micro-dispositif (100) selon la revendication 1, dans lequel le semi-conducteur comporte du Si et/ou dans lequel le métal comporte au moins l'un des éléments chimiques suivants : W, Ti, Co, Ru, Ta, Pt, Ni, et/ou dans lequel les premier et deuxième matériaux aptes à résister à la gravure HF comportent au moins l'un des composés chimiques suivants : Si, SiN, AlN, Al₂O₃, HfO₂.

3. Micro-dispositif (100) selon l'une des revendications précédentes, dans lequel le premier élément (101) fait partie d'un élément fixe du micro-dispositif (100).

4. Micro-dispositif (100) selon l'une des revendications précédentes, comportant en outre un substrat (102) auquel le premier élément (101) est relié par au moins une portion diélectrique (104).

5. Micro-dispositif (100) selon la revendication 4, comportant en outre un ou plusieurs composants microélectroniques réalisés sur le substrat (102).

6. Micro-dispositif (100) selon l'une des revendications précédentes, comportant en outre au moins un deuxième élément (114) relié au premier élément (101) parau moins une portion semi-conductrice (112) disposée entre le deuxième élément (114) et l'une des première et deuxième couches de protection (108, 110).

7. Micro-dispositif (100) selon l'une des revendications précédentes, dans lequel le premier élément (101) comporte en outre au moins un espaceur (138) recouvrant au moins une partie des faces latérales, sensiblement perpendiculaires aux deux faces opposées, de la portion de matériau (106) du premier élément (101) et comprenant au moins un troisième matériau apte à résister à la gravure HF.

8. Micro-dispositif (100) selon l'une des revendications précédentes, dans lequel l'autre des premier et deuxième matériaux aptes à résister à la gravure HF comporte le semi-conducteur ou un matériau diélectrique.

9. Procédé de réalisation d'un micro-dispositif (100), au cours duquel au moins un premier élément (101) du micro-dispositif (100) est réalisé en mettant en œuvre au moins les étapes de :
- réalisation d'un empilement d'une première couche (120) et de deux deuxièmes couches (118, 122) telles que la première couche (120) soit disposée entre les deux deuxièmes couches (118, 122), que la première couche (120) comporte au moins un métal, que l'une des deux deuxièmes couches (118, 122) comprenne au moins un premier matériau apte à résister à une gravure HF, que l'autre des deux deuxièmes couches (118, 122) comprenne au moins un deuxième matériau apte à résister à la gravure HF, et qu'au moins l'un des premier et deuxième matériaux aptes à résister à la gravure HF comporte un semi-conducteur;
- traitement thermique faisant réagir une partie du semi-conducteur avec le métal, formant une portion de matériau (106) correspondant à un composé du semi-conducteur et du métal, et tel qu'au moins une partie restante de chacune des deux deuxièmes couches (118, 122) forment des première et deuxième couches de protection (108, 110) recouvrant chacune une de deux faces opposées de ladite portion de matériau (106) et telles que les première et deuxième couches de protection (108, 110) soient en contact direct avec ladite portion de matériau (106) ;
et comprenant en outre la mise en œuvre d'une étape de gravure HF au cours de laquelle ladite portion de matériau (106) est protégée du HF par les première et deuxième couches de protection (108, 110).

10. Procédé selon la revendication 9, comportant en outre, après l'étape de réalisation de l'empilement, une étape de gravure de l'empilement des première et deuxièmes couches (118, 120, 122) selon un motif définissant géométriquement au moins le premier élément (101).

11. Procédé selon l'une des revendications 9 ou 10, comportant en outre, après l'étape de réalisation de l'empilement, les étapes de :
- dépôt d'une couche diélectrique (130) recouvrant au moins des portions restantes (106, 108, 110, 124, 126, 128) de l'empilement ;
- gravure d'une partie de la couche diélectrique (130), formant au moins un accès (132) au premier élément (101) ;
- dépôt d'un matériau semi-conducteur dans l'accès (132) formé à travers la couche diélectrique (130) et sur la couche diélectrique (130), formant un deuxième élément (114) relié au premier élément (101) par au moins une portion (112) de semi-conducteur disposée entre le deuxième élément (114) et le premier élément (101) ;
et dans lequel l'étape de gravure HF est mise en œuvre telle qu'elle supprime la couche diélectrique (130).

12. Procédé selon l'une des revendications 9 à 11, comportant en outre, avant la mise en œuvre de la gravure HF, une étape de réalisation d'au moins un espaceur (138) recouvrant au moins une partie des faces latérales, sensiblement perpendiculaires aux deux faces opposées, de la portion de matériau (106) du premier élément (101) et comprenant au moins un troisième matériau apte à résister à la gravure HF.

13. Procédé selon l'une des revendications 9 à 12, dans lequel l'empilement est réalisé sur une autre couche diélectrique (116) disposée sur un substrat (102).

14. Procédé selon la revendication 13, dans lequel l'étape de gravure HF grave également ladite autre couche diélectrique (116) telle qu'au moins une portion restante (104) de ladite autre couche diélectrique (116) relie le premier élément (101) au substrat (102).

15. Procédé selon l'une des revendications 13 ou 14, comportant en outre la réalisation d'un ou plusieurs composants microélectroniques sur le substrat (102).

## Patentansprüche

1. Mikrovorrichtung (100), umfassend wenigstens ein erstes Element (101), welches wenigstens umfasst:
- einen Materialabschnitt (106), der einer Verbindung von wenigstens einem Halbleiter und wenigstens einem Metall entspricht,
- eine erste und eine zweite Schutzschicht (108, 110), die jeweils eine von zwei gegenüberliegenden Seiten des Materialabschnitts (106) bedecken, so dass die erste und die zweite Schutzschicht (108, 110) in direktem Kontakt mit dem Materialabschnitt (106) stehen, dass die erste Schutzschicht (108) wenigstens ein erstes Material umfasst, das dazu geeignet ist, einem HF-Ätzen standzuhalten, dass die zweite Schutzschicht (110) wenigstens ein zweites Material umfasst, das dazu geeignet ist, dem HF-Ätzen standzuhalten, und dass wenigstens eines von dem ersten und dem zweiten Material, die dazu geeignet sind, dem HF-Ätzen standzuhalten, den Halbleiter umfasst.

2. Mikrovorrichtung (100) nach Anspruch 1, wobei der Halbleiter Si umfasst oder/und wobei das Metall wenigstens eines der folgenden chemischen Elemente umfasst: W, Ti, Co, Ru, Ta, Pt, Ni, oder/und wobei das erste und das zweite Material, die dazu geeignet sind, dem HF-Ätzen standzuhalten, wenigstens eine der folgenden chemischen Verbindungen umfassen: Si, SiN, AlN, Al₂O₃, HfO₂.

3. Mikrovorrichtung (100) nach einem der vorhergehenden Ansprüche, wobei das erste Element (101) Teil eines festen Elements der Mikrovorrichtung (100) ist.

4. Mikrovorrichtung (100) nach einem der vorhergehenden Ansprüche, ferner umfassend ein Substrat (102), mit dem das erste Element (101) durch wenigstens einen dielektrischen Abschnitt (104) verbunden ist.

5. Mikrovorrichtung (100) nach Anspruch 4, ferner umfassend eine oder mehrere auf dem Substrat (102) erzeugte mikroelektronische Komponenten.

6. Mikrovorrichtung (100) nach einem der vorhergehenden Ansprüche, ferner umfassend wenigstens ein zweites Element (114), das mit dem ersten Element (101) durch wenigstens einen Halbleiterabschnitt (112) verbunden ist, der zwischen dem zweiten Element (114) und einer von der ersten und zweiten Schutzschicht (108, 110) angeordnet ist.

7. Mikrovorrichtung (100) nach einem der vorhergehenden Ansprüche, wobei das erste Element (101) ferner wenigstens einen Abstandhalter (138) umfasst, der wenigstens einen Teil der Seitenflächen des Materialabschnitts (106) des ersten Elements (101) bedeckt, die im Wesentlichen senkrecht zu den zwei gegenüberliegenden Seiten verlaufen; und der wenigstens ein drittes Material umfasst, das dazu geeignet ist, dem HF-Ätzen standzuhalten.

8. Mikrovorrichtung (100) nach einem der vorhergehenden Ansprüche, wobei das andere von dem ersten und dem zweiten Material, die dazu geeignet sind, dem HF-Ätzen standzuhalten, den Halbleiter oder ein dielektrisches Material umfasst.

9. Verfahren zur Herstellung einer Mikrovorrichtung (100), wobei wenigstens ein erstes Element (101) der Mikrovorrichtung (100) hergestellt wird, indem wenigstens die folgenden Schritte ausgeführt werden:
- Herstellen eines Stapels aus einer ersten Schicht (120) und zwei zweiten Schichten (118, 122), so dass die erste Schicht (120) zwischen den beiden zweiten Schichten (118, 122) angeordnet ist, dass die erste Schicht (120) wenigstens ein Metall umfasst, wobei die eine der beiden zweiten Schichten (118, 122) wenigstens ein erstes Material umfasst, das dazu geeignet ist, einem HF-Ätzen standzuhalten, dass die andere der beiden zweiten Schichten (118, 122) wenigstens ein zweites Material umfasst, das dazu geeignet ist, dem HF-Ätzen standzuhalten, und wobei wenigstens das eine von dem ersten und dem zweiten Material, die dazu geeignet sind, dem HF-Ätzen standzuhalten, einen Halbleiter umfasst;
- Wärmebehandlung, bei der ein Teil des Halbleiters mit dem Metall zum Reagieren gebracht wird, wobei ein Materialabschnitt (106) gebildet wird, der einer Verbindung des Halbleiters und des Metalls entspricht, und so dass wenigstens ein verbleibender Teil von jeder der beiden zweiten Schichten (118, 122) erste und zweite Schutzschichten (108, 110) bilden, die jeweils eine von zwei gegenüberliegenden Seiten des Materialabschnitts (106) bedecken, und so dass sich die erste und zweite Schutzschicht (108, 110) in direktem Kontakt mit dem Materialabschnitt (106) befinden;
und weiter umfassend das Durchführen eines Schritts des HF-Ätzens, bei dem der Materialabschnitt (106) durch die erste und die zweite Schutzschicht (108, 110) vor dem HF geschützt ist.

10. Verfahren nach Anspruch 9, ferner umfassend, nach dem Schritt des Herstellens des Stapels, einen Schritt des Ätzens des Stapels aus den ersten und zweiten Schichten (118, 120, 122) gemäß einem Muster, das geometrisch wenigstens das erste Element (101) definiert.

11. Verfahren nach einem der Ansprüche 9 oder 10, ferner umfassend, nach dem Schritt des Herstellens des Stapels, die Schritte:
- Aufbringen einer dielektrischen Schicht (130), die wenigstens verbleibende Abschnitte (106, 108, 110, 124, 126, 128) des Stapels bedeckt;
- Ätzen eines Teils der dielektrischen Schicht (130), wodurch wenigstens ein Zugang (132) zum ersten Element (101) gebildet wird;
- Aufbringen eines Halbleitermaterials in dem durch die dielektrische Schicht (130) und auf der dielektrischen Schicht (130) gebildeten Zugang (132), wobei ein zweites Element (114) gebildet wird, das mit dem ersten Element (101) durch wenigstens einen Halbleiter-Abschnitt (112) verbunden ist, der zwischen dem zweiten Element (114) und dem ersten Element (101) angeordnet ist;
und wobei der Schritt des HF-Ätzens so durchgeführt wird, dass er die dielektrische Schicht (130) beseitigt.

12. Verfahren nach einem der Ansprüche 9 bis 11, ferner umfassend, vor der Durchführung des HF-Ätzens, einen Schritt des Herstellens wenigstens eines Abstandhalters (138), der wenigstens einen Teil der Seitenflächen des Materialabschnitts (106) des ersten Elements (101) bedeckt, die im Wesentlichen senkrecht zu den beiden gegenüberliegenden Seiten verlaufen, und der wenigstens ein drittes Material umfasst, das dazu geeignet ist, dem HF-Ätzen standzuhalten.

13. Verfahren nach einem der Ansprüche 9 bis 12, wobei der Stapel auf einer anderen dielektrischen Schicht (116) hergestellt wird, die auf einem Substrat (102) angeordnet ist.

14. Verfahren nach Anspruch 13, wobei der Schritt des HF-Ätzens auch die andere dielektrische Schicht (116) so ätzt, dass wenigstens ein verbleibender Abschnitt (104) der anderen dielektrischen Schicht (116) das erste Element (101) mit dem Substrat (102) verbindet.

15. Verfahren nach einem der Ansprüche 13 oder 14, ferner umfassend die Herstellung einer oder mehrerer mikroelektronischer Komponenten auf dem Substrat (102).

## Claims

1. Micro-device (100) including at least one first element (101) comprising at least:
- a portion of material (106) corresponding to a compound of at least one semi-conductor and at least one metal,
- first and second protective layers (108, 110) each covering one of two opposite faces of said portion of material (106), such that the first and second protective layers (108, 110) are in direct contact with said portion of material (106), that the first protective layer (108) comprises at least one first material able to withstand an HF etching, that the second protective layer (110) comprises at least one second material able to withstand the HF etching, and that at least one of the first and second materials able to withstand the HF etching includes the semi-conductor.

2. Micro-device (100) according to claim 1, wherein the semi-conductor includes Si and/or the metal includes at least one of the following chemical elements: W, Ti, Co, Ru, Ta, Pt, Ni, and/or wherein the first and second materials able to withstand the HF etching include at least one of the following chemical compounds: Si, SiN, AlN, Al₂O₃, HfO₂.

3. Micro-device (100) according to one of the preceding claims, wherein the first element (101) is part of a fixed element of the micro-device (100).

4. Micro-device (100) according to one of the preceding claims, further including a substrate (102) to which the first element (101) is connected by at least one dielectric portion (104).

5. Micro-device (100) according to claim 4, further including one or more micro-electronic components made on the substrate (102).

6. Micro-device (100) according to one of previous claims, further including at least one second element (114) connected to the first element (101) by at least one semi-conducting portion (112) arranged between the second element (114) and one of the first and second protective layers (108, 110).

7. Micro-device (100) according to one of previous claims, wherein the first element (101) further includes at least one spacer (138) covering at least one part of the side faces, which are substantially perpendicular to both opposite faces, of the portion of material (106) of the first element (101) and comprising at least one third material able to withstand the HF etching.

8. Micro-device (100) according to one of previous claims, wherein the other of the first and second materials able to withstand the HF etching includes the semi-conductor or a dielectric material.

9. Method for making a micro-device (100), during which at least one first element (101) of the micro-device (100) is made by implementing at least the steps of:
- making a stack of a first layer (120) and of two second layers (118, 122) such that the first layer (120) is arranged between the two second layers (118, 122), that the first layer (120) includes at least one metal, that one of the two second layers (118, 122) comprises at least one first material able to withstand an HF etching, that the other of the two second layers (118, 122) comprises at least one second material able to withstand the HF etching, and that at least one of the first and second materials able to withstand HF etching includes a semi-conductor;
- heat treating, reacting a part of the semi-conductor with the metal, forming a portion of material (106) corresponding to a compound of the semi-conductor and the metal, and such that at least one remaining part of each of the two second layers (118, 122) form first and second protective layers (108, 110) each covering one of two opposite faces of said portion of material (106) and such that the first and second protective layers (108, 110) are in direct contact with said portion of material (106) ;
and further comprising implementing a step of HF etching during which said portion of material (106) is protected from HF by the first and second protective layers (108, 110).

10. Method according to claim 9, further including, after the step of making the stack, a step of etching the stack of the first and second layers (118, 120, 122) with a pattern geometrically defining at least the first element (101).

11. Method according to one of claims 9 or 10, further including, after the step of making the stack, the steps of:
- depositing a dielectric layer (130) covering at least remaining portions (106, 108, 110, 124, 126, 128) of the stack;
- etching a part of the dielectric layer (130), forming at least one access (132) to the first element (101);
- depositing a semi-conductor material in the access (132) formed through the dielectric layer (130) and on the dielectric layer (130), forming a second element (114) connected to the first element (101) by at least one portion (112) of semi-conductor arranged between the second element (114) and the first element (101);
and wherein the step of HF etching is implemented such that it removes the dielectric layer (130).

12. Method according to one of claims 9 to 11, further including, before implementing the HF etching, a step of making at least one spacer (138) covering at least one part of the side faces, which are substantially perpendicular to both opposite faces, of the portion of material (106) of the first element (101) and comprising at least one third material able to withstand the HF etching.

13. Method according to one of claims 9 to 12, wherein the stack is made on another dielectric layer (116) arranged on a substrate (102).

14. Method according to claim 13, wherein the step of HF etching also etches said other dielectric layer (116) such that at least one remaining portion (104) of said other dielectric layer (116) connects the first element (101) to the substrate (102).

15. Method according to one of claims 13 or 14, further including making one or more micro-electronic components on the substrate (102).
